(19) Europäisches Patentamt
European Patent Office
Office européen des brevets

(11) **EP 4 776 514 A1**

(12) # EUROPEAN PATENT APPLICATION

(43) Date of publication:
**15.07.2026 Bulletin 2026/29**

(21) Application number: **26150420.3**

(22) Date of filing: **06.01.2026**

(51) International Patent Classification (IPC):
**H03M 1/06** $^{(2006.01)}$ **H03M 3/00** $^{(2006.01)}$

(52) Cooperative Patent Classification (CPC):
**H03M 1/066; H03M 3/338;** H03M 3/464

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **09.01.2025 IN 202541002149**

(71) Applicant: **NXP USA, Inc.
Austin, TX 78735 (US)**

(72) Inventor: **BALUNI, Alok
5656AG Eindhoven (NL)**

(74) Representative: **Schwarzweller, Thomas
NXP Semiconductors Germany GmbH
Intellectual Property Group
Beiersdorfstraße 12
22529 Hamburg (DE)**

(54) **DYNAMIC ELEMENT MATCHING FOR MULTI-BIT DIGITAL-TO-ANALOG CONVERTER IN CONTINUOUS-TIME DELTA SIGMA MODULATORS**

(57) A continuous-time delta-sigma modulator (CTDSM) system includes a quantizer, an update block, a switching block, a summation block, and a feedback path. The quantizer is configured to quantize an analog input signal into one or more thermometer-coded digital signals. The update block is configured to generate control signals based on the thermometer-coded digital signals. The switching block is configured to route the thermometer-coded digital signals to a plurality of digital-to- analog converter (DAC) elements based on the control signals. The plurality of DAC elements is configured to convert the thermometer-coded digital signals into analog outputs. The summation block is configured to combine the analog outputs from the plurality of DAC elements to produce a final analog output. The feedback path is configured to use the final analog output as a feedback signal for the CTDSM system.

FIG. 5

EP 4 776 514 A1

**Description**

**FIELD OF THE DISCLOSURE**

The present disclosure relates generally to continuous-time delta-sigma modulators and, more particularly, to techniques for implementing dynamic element matching (DEM) algorithms that address element mismatches in multi-bit digital-to-analog converters (DACs) to reduce non-linearity, tonal behavior, and implementation complexity.

**BACKGROUND**

Continuous-time delta-sigma modulators (CTDSMs) are widely used in high-performance analog-to-digital conversion systems due to their ability to achieve high signal-to-quantization noise ratio (SQNR) and robust stability with oversampling and noise shaping. In such systems, digital-to-analog converters (DACs) play a role in feedback loops, where their performance directly impacts the overall linearity and noise floor of the modulator.

CTDSMs traditionally employ single-bit DACs due to their inherent linearity, which eliminates concerns about element mismatches and their resulting nonlinearities. However, single-bit DACs limit the achievable SQNR and stability of the modulator. Multi-bit DACs, in contrast, offer the potential to improve SQNR, enhance stability, and reduce the oversampling ratio (OSR), enabling lower switching power. Despite these advantages, multi-bit DACs face significant challenges arising from element mismatches among their internal components. Element mismatches in multi-bit DACs, often due to process variations, result in nonlinear distortion and increased noise floor caused by intermodulation effects. These performance degradations pose challenges, particularly in high-resolution applications, where even minor mismatches can have substantial impacts.

**BRIEF DESCRIPTION OF THE DRAWINGS**

The accompanying figures, where like reference numerals refer to identical or functionally similar elements throughout the separate views, and which together with the detailed description below are incorporated in and form part of the specification, serve to further illustrate various embodiments and to explain various principles and advantages all in accordance with the present disclosure, in which:

FIG. 1 is a schematic diagram illustrating an example of a continuous-time delta-sigma modulator (CTDSM) system in accordance with some implementations;

FIG. 2 is a schematic diagram illustrating an example of a CTDSM system that applies dynamic element matching logic to a 3-level digital-to-analog converter in accordance with some implementations;

FIG. 3 is a schematic diagram illustrating an example of an update block in the CTDSM system of FIG. 2 for performing dynamic element matching in accordance with some implementations;

FIG. 4 is a schematic diagram illustrating an example of a CTDSM system that applies dynamic element matching logic to a 4-level digital-to-analog converter in accordance with some implementations;

FIG. 5 is a schematic diagram illustrating an example of an update block in the CTDSM system of FIG. 4 for performing dynamic element matching in accordance with some implementations;

FIG. 6 is a flow diagram of a method for performing dynamic element matching for a 3-level quantizer and two DAC units in accordance with some implementations; and

FIG. 7 is a flow diagram of a method for performing dynamic element matching for a 4-level quantizer and three DAC units in accordance with some implementations.

**DETAILED DESCRIPTION**

Element mismatches in multi-bit digital-to-analog converters (DACs) refer to variations in the physical or electrical characteristics of individual components, such as current sources, resistors, or capacitors, within the DAC. These mismatches, typically caused by manufacturing process variations, temperature fluctuations, or aging effects, result in discrepancies between components that are intended to be identical. In continuous-time delta-sigma modulators (CTDSMs), such mismatches lead to non-linear distortions and an increased noise floor, degrading the overall performance of the modulator. For instance, in a thermometer-coded multi-bit DAC, element mismatches can cause the output to deviate from its ideal value, introducing intermodulation effects and limiting system linearity. As CTDSMs strive to achieve higher signal-to-quantization noise ratios (SQNR) and stability, especially in high-resolution and high-speed applications, addressing these mismatch-induced issues has become a concern. Various techniques have been proposed to mitigate these effects, with dynamic element matching (DEM) being one of the most prominent solutions.

One example of mismatch-related challenges arises in a 2-bit CTDSM employing a tri-level DAC. In this configuration, the DAC output is determined by the sum of two thermometer-coded bits, T1 and T2, which drive the DAC elements. Element mismatches within the DAC, represented by $1 - \Delta$ and $1 + \Delta$, cause the DAC output to deviate from its ideal value. This mismatch-induced degradation manifests as increased non-linearity and a reduced signal-to-quantization noise ratio (SQNR). For instance, with just a 0.5% mismatch, the SQNR drops by, for example, 22 dB, and the second harmonic distortion (HD2) rises to, for example, approximately -60 dB, severely impacting the system's performance.

To address such mismatches, dynamic element randomization (DER) has been employed as a conventional solution. DER works by shuffling the thermometer bits, T1 and T2, before they are fed to the DAC elements. This shuffling is driven by a pseudo-random binary sequence (PRBS) generator, which ensures near-random behavior. The randomization effectively suppresses non-linear tones and harmonics caused by element mismatches, particularly in low-level input signals. However, this approach comes at the cost of increasing the noise floor. For example, power spectral density (PSD) analysis demonstrates that randomization raises the noise floor by, for example, approximately 6 dB compared to the non-randomized case. This trade-off between suppressing harmonics and increasing the noise floor highlights a limitation of DER in systems requiring high dynamic range and low-noise performance.

Another approach involves digital estimation and calibration to compensate for element mismatches. This method involves extracting mismatch-induced errors by correlating the filtered outputs of the DAC elements with the system output Y. The errors, represented as calibration outputs, are proportional to the mismatch factor $\Delta$. These values are used to generate an estimate $\Delta'$, which is then applied to correct the filtered outputs before combining them to produce the final output. While theoretically effective, this approach introduces significant practical challenges. The corrected outputs require high-precision fixed-point multiplication at the Nyquist rate, which is computationally intensive and power-hungry. Furthermore, the correlation and feedback process necessitates a complex timing loop that must close at the Nyquist rate. As system bandwidths increase, these timing constraints become increasingly difficult to meet, leading to high implementation complexity, increased power consumption, and potential performance bottlenecks.

These challenges with conventional approaches, including mismatch-induced performance degradation, noise floor increases with randomization, and the computational complexity of digital calibration, underscore the need for a simplified and effective solution.

As such, as described herein is an efficient dynamic element matching (DEM) technique for multi-bit DACs in continuous-time delta-sigma modulators (CTDSMs). The DEC techniques are implemented as part of the circuitry within CTDSM. In at least some implementations, the DEC techniques operates in the digital domain of the modulator's feedback loop to control the routing or shuffling of thermometer-coded input signals to the DAC elements (e.g., current sources, resistors, capacitors, etc.) in a manner that minimizes cumulative mismatch errors.

The DEM techniques described herein, eliminate tonal behavior caused by periodic effects and do not require any digital calibration, overcoming limitations of existing DEM techniques. By leveraging a novel toggling mechanism based on detecting mismatched conditions between DAC input signals, the cumulative mismatch error is forced to average to zero over time. This is achieved using minimal logic, such as an AND gate and simple control logic, to dynamically shuffle DAC elements in response to mismatched input patterns.

In at least some implementations, the DEM techniques described herein are configured for use with different DAC configurations, such as 3-level and 4-level DAC configurations, enabling the restoration of signal-to-quantization noise ratio (SQNR) to near-ideal levels even in the presence of, for example, 0.5% mismatch. The techniques avoid the periodicity associated with conventional element rotation or data-weighted averaging (DWA) schemes, thereby eliminating low-signal-level tones, while retaining the linearity benefits of randomization without increasing the noise floor. Furthermore, the technique is area- and power-efficient, introduces negligible logic delay, and is well-suited for high-speed applications. As such. The techniques described herein simplifies the implementation of DEM while ensuring robust performance across a wide range of operating conditions.

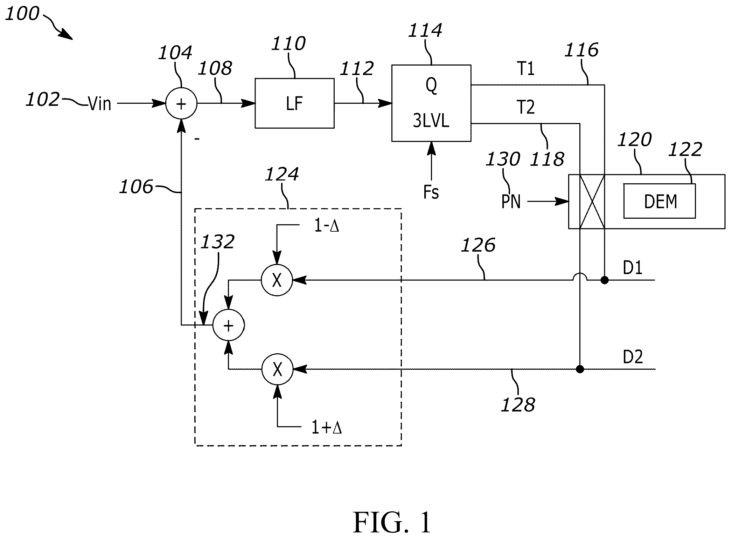

FIG. 1 illustrates a schematic diagram of a continuous-time delta-sigma modulator (CTDSM) system 100. This system 100 is configured with a switching block that implements a dynamic element matching (DEM) logic to mitigate mismatch errors in a multi-bit digital-to-analog converter (DAC). The DEM logic enhances the linearity and performance of the DAC by dynamically shuffling the digital signals to average out component mismatches over time.

The CTDSM 100 processes an input signal $V_{in}$ 102, which is the analog signal intended for high-resolution digital conversion. One objective of the CTDSM 100 is to convert this analog input into a precise digital output while suppressing quantization noise within the signal bandwidth. The input signal $V_{in}$ 102 is first supplied to a summing block 104. In this block 104, a feedback signal 106, which is derived from the DAC output, $DAC_{out}$ 132, is subtracted from the input signal $V_{in}$

102 to generate an error signal 108. This operation is part of the delta-sigma modulation process, as it forms the basis for noise shaping and error correction within the modulator 100. This error signal 108 represents the instantaneous difference between the desired input and the current system output, which is important for adjusting the modulator's behavior in subsequent stages.

The error signal 108 is then processed by a loop filter 110. The loop filter 110 is a component that shapes the quantization noise introduced by the quantizer 114. By appropriately configuring the loop filter's transfer function, the system 100 can push the quantization noise out of the signal band (a process known as noise shaping), thereby improving the signal-to-noise ratio (SNR) within the desired frequency range. The output of the loop filter 110 is a filtered signal 112 that emphasizes the error components at frequencies where noise suppression is most needed.

The filtered signal 112 from the loop filter 110 is fed into an N-level quantizer 114, such as a 3-level or 4-level quantizer. The quantizer 114 operates at the sampling frequency $F_s$, which is also input to the quantizer 114 to ensure precise timing and synchronization. The quantizer 114 converts the continuous-time, filtered analog signal into discrete digital levels. In this example, the quantizer produces two thermometer-coded digital outputs, denoted as $T_1$ 116 and $T_2$ 118. Thermometer coding is advantageous because it ensures monotonicity and reduces the possibility of glitches during digital transitions, which is used for maintaining DAC linearity.

The thermometer-coded outputs $T_1$ and $T_2$ are routed to a switching block 120, which implements the DEM logic 122. The switching block 120 dynamically shuffles the digital signals $T_1$ and $T_2$ before they are supplied to the DAC system 124 via flip-flop outputs $D_1$ 126 and $D_2$ 128. The flip-flops ensure proper timing and synchronization of the dynamically shuffled signals. The output $D_1$ and $D_2$ of the flip-flops are then fed into the DAC system 124, where the digital signals are converted into analog outputs. The term "dynamically," as used herein, refers to operations or processes that adjust in real-time or in response to changing conditions or inputs. For example, in the context of dynamically routing thermometer-coded signals, it involves adjusting the paths or assignments of these signals based on detected mismatch conditions or pre-determined sequences, such as those generated by pseudo-random sequence logic. This ensures that the routing is not fixed or static but instead varies adaptively during operation.

The DEM logic 122 within the switching block 120 controls the shuffling of the signals $T_1$ and $T_2$ by utilizing a pseudo-random binary sequence (PN) generator 130. The PN generator 130 toggles the routing of $T_1$ and $T_2$ based on mismatch conditions detected when $T_1 \neq T_2$, ensuring proper dynamic routing to mitigate mismatch errors in the DAC system 124. The DEM logic 122, in at least some implementations, averages out mismatch-induced errors over time. Due to process variations, the components of the DAC system 124 may not be perfectly matched, leading to distortion in the output signal. By dynamically switching $T_1$ and $T_2$ based on the PN sequence from the PN generator 130, the DEM logic 122 ensures that the errors introduced by mismatches are randomized and, thus, can be filtered out by the loop filter 110.

The DAC system 124 includes one or more DAC elements (also referred to herein as DACs), which convert the dynamically shuffled thermometer-coded digital signals $T_1$ and $T_2$ into an analog feedback signal. The DACs have inherent mismatches with a gain of 1 - Δ and a gain of 1 + Δ. Here, Δ represents the degree of mismatch between the DACs, typically a small percentage due to manufacturing variations.

The DAC output, $DAC_{out}$ 132, is calculated using the contributions ($D_1$ and $D_2$) from flip-flops having, such that

$$DAC_{out} = D_1 \cdot (1 - \Delta) + D_2 \cdot (1 + \Delta) \ (EQ.\ 1).$$

The expressions for the output of the flip-flops $D_1$ and $D_2$, are defined based on the PN sequence from the PN generator 130, which takes binary values of {1, 0}:

$$D_1 = (T_1 \cdot PN) + (T_2 \cdot (1 - PN)) \quad (EQ.\ 2)$$

$$D_2 = (T_2 \cdot PN) + (T_1 \cdot (1 - PN)) \quad (EQ.\ 3)$$

Substituting $D_1$ and $D_2$ back into the expression for $DAC_{out}$ 132, the following is obtained:

$DAC_{out}$ = [($T_1 \cdot PN$) + ($T_2 \cdot$ (1 - $PN$)] $\cdot$ (1 - Δ) + [($T_2 \cdot PN$) + ($T_1 \cdot$ (1 - $PN$)] $\cdot$ (1 + Δ) = $T_1$ + $T_2$ + Δ $\cdot$ ($T_2$ - $T_1$) $\cdot$ (2 $\cdot$ $PN$ - 1) (EQ. 4).  (EQ. 4).

In this equation, 2 · *PN* - 1 can be redefined as an effective PN sequence, $PN_{eff}$, which alternates between -1 and +1. This mapping is used for analyzing the error terms:

$$PN_{eff} = 2 \cdot PN - 1 \text{ with } PN \in \{0,1\}, PN_{eff} \in \{-1, +1\} \quad (EQ.\ 5).$$

From the DAC output equation, EQ. 4, the mismatch-induced error term is:

$$Error\ Term = \Delta \cdot (T_2 - T_1) \cdot PN_{eff} \qquad (EQ.\ 6).$$

This error term is directly proportional to the degree of mismatch $\Delta$, the difference between $T_1$ and $T_2$, and the effective PN sequence $PN_{eff}$. When $T_1 = T_2$, the error term becomes zero because $T_2 - T_1 = 0$. However, when $T_1 \neq T_2$, the error term can accumulate over time, leading to distortion in the output signal.

Table A below provides examples of $DAC_{out}$ 132 and the associated *Error Term* based on different combinations of $T_1$ and $T_2$, and $PN_{eff}$:

TABLE A

| $PN_{eff}$ | $T_1$ | $T_2$ | $DAC_{out}$ | Error Term |
|---|---|---|---|---|
| X | 1 | 1 | 2 | 0 |
| 1 | 1 | -1 | -2Δ | -2Δ |
| -1 | 1 | -1 | 2Δ | 2Δ |
| X | -1 | -1 | -2 | -0 |

In this table, when $T_1 = T_2$, the *Error Term* is zero and when $T_1 \neq T_2$, the *Error Term* is non-zero and depends on $PN_{eff}$.

The cumulative error over multiple samples is expressed as:

$$Cumulative\ Error = -2 \cdot \Delta \cdot \sum_i PN_{eff}[i] \qquad (EQ.\ 7),$$

where the summation is taken over all indices $i$ where $T_1 \neq T_2$. Without proper management, this cumulative error can grow over time, degrading the performance of the DAC system 124.

In at least some implementations, to minimize the *Cumulative Error,* the DEM logic 122 within the switching block 120 toggles the PN bit every time the condition $T_1 \neq T_2$ is detected. By doing so, the DEM logic 122 ensures that $\sum_i PN_{eff}[i] = 0$ over multiple samples. This effectively forces the cumulative error to average to zero, as the positive and negative error contributions cancel each other out.

Table B below illustrates the PN toggling logic:

TABLE B

| $T_1$ | $T_2$ | $PN_{j+1}$ |
|---|---|---|
| -1 | -1 | $PN_i$ |
| 1 | -1 | $1 - PN_i$ |
| 1 | 1 | $PN_i$ |

In this table, if $T_1 = T_2$, the next PN state , $PN_{j+1}$, remains the same as the current state, $PN_i$. If $T_1 \neq T_2$, the PN state toggles its state ($PN_{j+1} = 1 - PN_i$). This logic ensures that the error terms alternate in sign when $T_1 = T_2$, leading to cancelation over time.

The output, $DAC_{out}$ 132, of the DAC system 124 is routed back through a feedback path 106 to the summing block 104, completing the feedback loop of the CTDSM 100. This feedback provides noise shaping by pushing the quantization noise out of the signal band, improving the signal-to-noise ratio in the desired frequency range. The feedback also facilitates error correction by continuously adjusting the modulator's output based on the difference between the input signal $V_{in}$ 102 and $DAC_{out}$ 132, ensuring accurate operation. Additionally, the feedback mechanism maintains the stability of the system, ensuring proper operation of the modulator across various operating conditions.

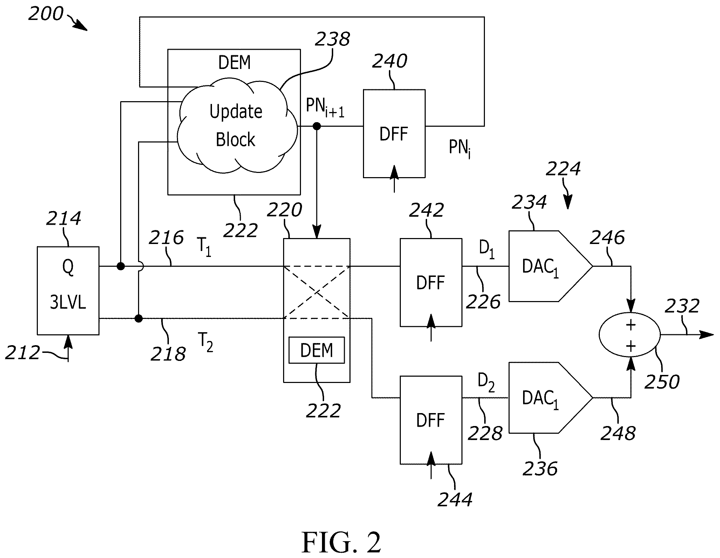

Building upon the CTDSM architecture and DEM logic principles described above with respect to FIG. 1, FIG. 2 and FIG. 3 illustrate an example of a schematic for a CTDSM system 200 that applies DEM logic 222 to a 3-level DAC configuration. FIG. 2 illustrates an example practical aspect of integrating the DEM logic 222 into the CTDSM system 200 and demonstrates its effectiveness through performance verification. As described below, the DEM logic 222 is distributed across multiple components of the CTDSM system 200.

In at least some implementations, the system 200 includes a with a 3-level quantizer 214, which receives an input signal 212, such as the filtered signal 112 described above with respect to FIG. 1, and produces two thermometer-coded

outputs, $T_1$ 216 and $T_2$ 218. These outputs represent the quantized levels of the input signal and are used for high-resolution digital and other processing. The quantizer 214 converts the continuous-time, filtered analog signal into discrete digital levels, enabling precise digital representation of the analog input.

The thermometer-coded signals $T_1$ and $T_2$ are routed into a switching block 220, which implements the DEM logic 222 by dynamically shuffling these signals based on the state of the pseudo-random binary sequence $PN_i$. The purpose of this dynamic shuffling is to average out mismatch errors between the DACs 234, 236 over time, thereby enhancing the linearity and performance of the DAC system 224. By controlling the routing of $T_1$ and $T_2$, the system 100 minimizes the cumulative effect of component mismatches.

An update block 238, which is part of the DEM logic 222, generates the next state of the pseudo-random sequence, $PN_{i+1}$, as a function of the current state $PN_i$ and the thermometer-coded signals $T_1$ and $T_2$. In at least some implementations, the update block uses an exclusive OR (XOR) gate to detect conditions where $T_1 \neq T_2$. For example, the update block 238 uses an exclusive OR (XOR) gate to detect conditions where $T_1 \neq T_2$. When this condition is detected, the state of $PN_{i+1}$ is toggled (i.e., $PN_{i+1} = 1 - PN_{i+}$), ensuring proper dynamic routing in the switching block 220, which also includes at least a portion of the DEM logic 222. This operation is used for minimizing cumulative mismatch-induced errors. The next state, $PN_{i+1}$, is passed to a flip-flop 240, which stores the updated value and provides the current state, $PN_{i+1}$, to the switching block 220. This ensures that the dynamic routing of $T_1$ and $T_2$ into the DACs 234, 236 is synchronized with the system clock, maintaining timing accuracy throughout the system 100.

In at least some implementations, the switching block 220 dynamically routes the thermometer-coded signals $T_1$ and $T_2$ into two additional flip-flops 242, 244 having outputs $D_1$ 226 and $D_2$ 228, before driving the DACs 234, 236. These flip-flops 242, 244 ensure that the signals are correctly timed and help prevent glitches that could degrade the DACs' performance. By aligning the signals with the clock edges, the system 100 maintains consistent operation and reduces the likelihood of transient errors.

The DACs 234, 236 are elements of a multi-bit DAC system 224. They convert the dynamically routed thermometer-coded digital signals $T_1$ and $T_2$ into analog outputs. Due to inherent process variations, the DACs 234, 236 may exhibit mismatches represented as $1 - \Delta$ and $1 + \Delta$, respectively, where $\Delta$ represents the degree of mismatch. These mismatches can cause distortion in the output signal if not properly managed. The analog outputs 246, 248 from the DACs 234, 236 are summed together using a summation block 250, producing the final DAC output, $DAC_{out}$ 232. This output is then used as a feedback signal (e.g., signal 106 in FIG. 1) in the delta-sigma modulation loop to maintain system stability and performance.

The operation of the system 200 involves various processes working together to achieve high-performance digital-to-analog conversion. Initially, the quantizer 214 generates the thermometer-coded digital signals $T_1$ and $T_2$ from the modulated input signal 212. These signals represent the quantized levels necessary for digital processing. The update block 238 then determines the next state of the pseudo-random sequence , $PN_{i+1}$, based on the current state , $PN_i$, and the condition $T_1 \neq T_2$. By using an XOR gate to detect when $T_1$ and $T_2$ differ, the system 100 identifies when mismatch errors could accumulate.

When a mismatch condition is detected ( $T_1 \neq T_2$), the update block 238 toggles the pseudo-random sequence by setting $PN_{i+1} = 1 - PN_{i+1}$). This toggling ensures that the mismatch-induced errors will alternate in sign in subsequent cycles, effectively canceling out over time. The flip-flop 240 stores this next state $PN_{i+1}$ and provides the updated current state $PN_i$ to the switching block 220. This synchronization with the system clock is helps maintain the correct timing of signal routing.

With the updated $PN_i$, the switching block 220 dynamically shuffles $T_1$ and $T_2$ before routing them into the flip-flops 242, 244. The dynamic shuffling based on $PN_i$, redistributes the signals to the DACs 234, 236 in a way that averages out the effects of mismatches. The flip-flops 242, 244 further ensure that the shuffled signals are synchronized with the system clock before driving the DACs 234, 236, maintaining consistent timing and reducing potential errors.

The DACs 234, 236 then convert the dynamically routed digital signals into analog outputs, taking into account their respective mismatches. By averaging the mismatch-induced errors through dynamic shuffling, the DEM logic 222 helps the system 100 minimize distortion in the analog outputs. The analog outputs 246, 248 from the DACs 234, 236 are combined in a summing block 250, producing the final DAC output, $DAC_{out}$ 232. This output serves as a feedback signal in the CTDSM loop, allowing the system to adjust and maintain high accuracy and stability.

The effectiveness of the system 200 was verified using a 4th-order continuous-time delta-sigma modulator with an oversampling ratio (OSR) of 25 and an optimized noise shaping configuration. The ideal SQNR achieved was 82 dB, indicating high-fidelity signal processing. However, when a mismatch of 0.5% ( $\Delta = 0.005$) was introduced between the DACs, the SQNR degraded to 61.2 dB, and significant second harmonic distortion was observed due to the mismatch-induced errors.

By employing the DEM logic 222, the system 200 effectively averaged out these mismatch-induced errors. The dynamic shuffling of $T_1$ and $T_2$ based on the toggling of $PN_i$, restored the SQNR to 81.6 dB, closely approaching the ideal performance. This significant improvement demonstrates the effectiveness of the DEM logic 222 in mitigating mismatch errors and enhancing overall system performance. The reduction in harmonic distortion confirms that the DEM logic successfully neutralizes the adverse effects of component mismatches.

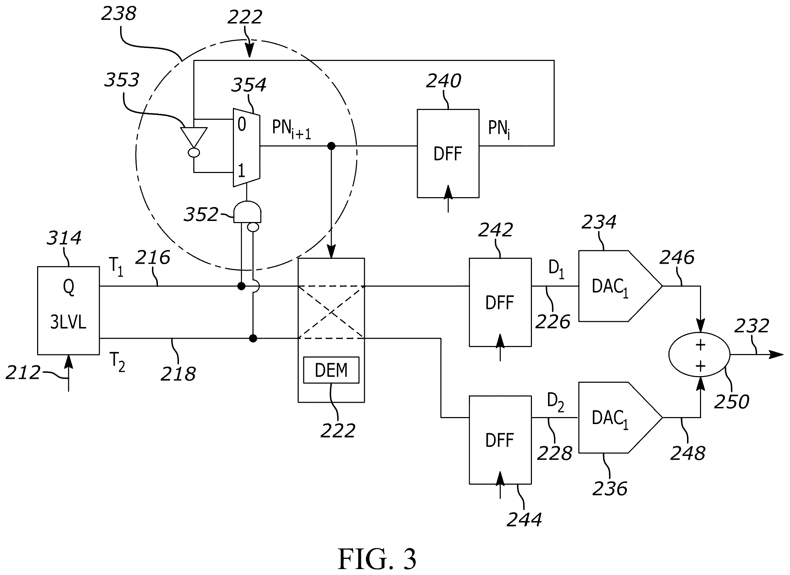

FIG. 3 illustrates one example configuration of the update block 238 in the system 200 of FIG. 2. In this example, the update block 238 employs an AND gate 352 and a NOT gate 353 to detect the condition where $T_1 \neq T_2$ and controls the toggling of the pseudo-random sequence bit $PN_{i+1}$. By simplifying the logic required for the DEM logic 222, this implementation ensures effective mitigation of mismatch errors in the multi-bit DAC system 224 while maintaining system synchronization.

In this configuration, the update block 238 uses a logic circuit to determine the next state of the pseudo-random sequence $PN_{i+1}$ based on the current $PN_i$ state and the relationship between $T_1$ and $T_2$. The AND gate 352 detects the condition where $T_1 \neq T_2$, indicating a mismatch. The output of the AND gate 352 triggers the subsequent logic that updates $PN_{i+1}$. The NOT gate 353 is used to generate the complement of the current state $PN_i$. This complement 1 - $PN_i$ serves as one of the inputs to a multiplexer (MUX) 354.

The MUX 354 is used to toggle the $PN_{i+1}$ bit when $T_1 \neq T_2$ is detected. The MUX 354 selects between the current $PN_i$ state and its complement 1 - $PN_i$, allowing for controlled toggling. The MUX 354 selects the appropriate input based on the output of the AND gate 352. As described above, a flip-flop 240 stores the updated pseudo-random sequence $PN_{i+1}$ and provides it as the current state $PN_i$ for use in the switching block 220. The flip-flop 240 ensures that the toggling is synchronized with the system clock, maintaining proper timing within the circuit.

In operation, the thermometer-coded outputs $T_1$ and $T_2$ are fed into the AND gate 352. The AND gate 352 evaluates whether $T_1 \neq T_2$, indicating a mismatch triggering the $PN_{i+1}$ bit to toggle. The output of the AND gate 352 serves as a select signal for the multiplexer 354. When $T_1 \neq T_2$, the MUX toggles 354 $PN_{i+1}$ by selecting the complement of the current state $PN_i$. When $T_1 = T_2$, the MUX 354 maintains the current $PN_i$ state. The up dated pseudo-random bit $PN_{i+1}$ is stored in the flip-flop 240, ensuring synchronization with the system clock and readiness for use in the switching block 220.

The updated $PN_i$ from the update block 238 is then fed into the switching block 220, which uses the pseudo-random sequence to dynamically shuffle the thermometer-coded signals $T_1$ and $T_2$ before they are routed to the DACs 234, 236. This dynamic shuffling effectively averages out mismatch-induced errors over time, improving the DAC's performance. By updating $PN_i$ to its complement when $T_1 \neq T_2$, the system 100 ensures that positive and negative mismatch errors alternate, leading to error cancelation over multiple cycles.

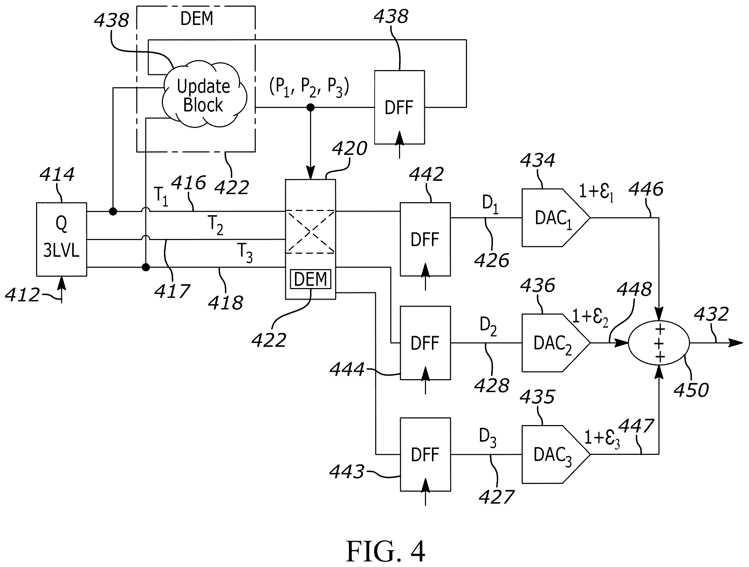

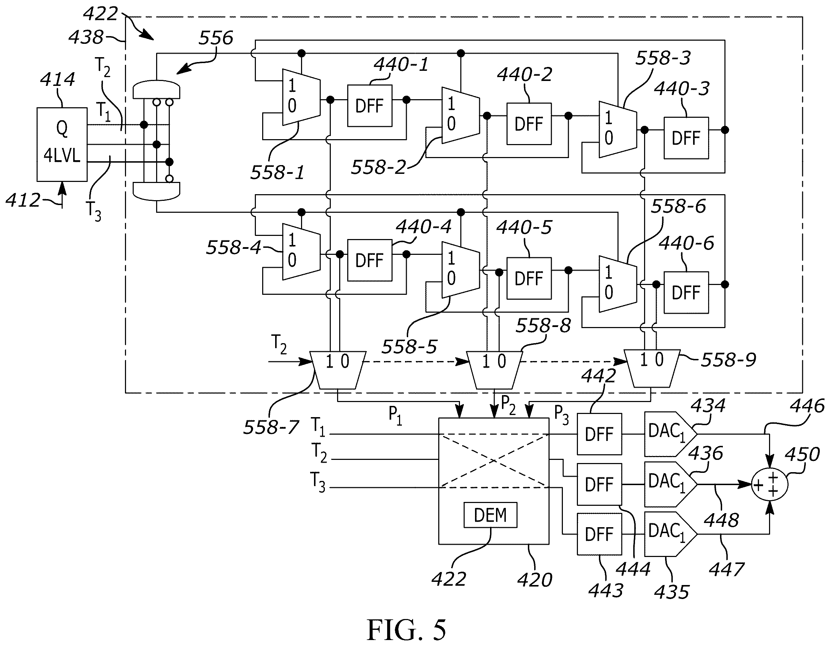

FIG. 4 and FIG. 5 are schematics of another example of a CTDSM system 400 that applies DEM logic 422 to a 4-level DAC configuration. This example configuration demonstrates how DEM logic can be extended to a configuration with three DAC units to further enhance performance by averaging out mismatch-induced errors across multiple elements. As described below, the DEM logic 422 is distributed across multiple components of the CTDSM system 400.

In at least some implementations, the system 400 includes a 4-level quantizer 414, which receives the modulated an input signal 412, such as the filtered signal 112 described above with respect to FIG. 1, and produces three thermometer-coded outputs $T_1$ 416, $T_2$ 418, $T_3$ 417. These signals represent the quantized levels of the input signal, enabling high-resolution digital-to-analog conversion. The quantizer 414 converts the continuous-time, filtered analog signal into discrete digital levels, which are then dynamically shuffled to mitigate mismatch errors.

The thermometer-coded signals $T_1$, $T_2$, $T_3$ are routed into a switching block 420, which implements the DEM logic 422. The DEM logic 422 dynamically shuffles these signals based on control bits $p_1$, $p_2$, $p_3$ generated by the update block 438 as a function of the signals $T_1$, $T_2$, and $T_3$. The update block 438 determines the next state of the control bits $p_1$, $p_2$, $p_3$ based on the current state and the signals $T_1$, $T_2$, $T_3$. To ensure proper synchronization, the next state of the control bits is stored in a flip-flop 440, which provides the updated state to the switching block 420. This ensures that the dynamic routing of $T_1$, $T_2$, and $T_3$ is synchronized with the system clock, maintaining timing accuracy throughout the system 400. The dynamic shuffling of $T_1$, $T_2$, and $T_3$ averages out mismatch errors between the DACs 434, 435, 436 over time. By controlling the routing of $T_1$, $T_2$, and $T_3$, the system 400 minimizes the cumulative effect of component mismatches.

The system 400 includes three DACs 434-436 with normalized weights $1 + \varepsilon_1$, $1 + \varepsilon_2$, $1 + \varepsilon_3$. These weights represent the inherent mismatches in the DACs 434-436 due to process variations. When the common-mode component is excluded, the mismatches satisfy the condition that the mismatch weights $\varepsilon_1$, $\varepsilon_2$, $\varepsilon_3 = 0$. This condition ensures that the total mismatch is balanced across all DACs 434-436, facilitating effective error cancelation through the DEM logic 422.

The control bits $p_1$, $p_2$, $p_3$ are used by the DEM logic 422 to control the shuffling of $T_1$, $T_2$, $T_3$ to flip-flops 442-444, which drive the DACs 434-436. Specifically, they determine how the thermometer-coded signals $T_1$, $T_2$, $T_3$ are dynamically routed to the DACs 434-436 according to the following equations:

$$D_1 = T_1 \cdot p_1 + T_2 \cdot p_2 + T_3 \cdot p_3 \quad (\text{EQ. 8}),$$

$$D_2 = T_1 \cdot p_2 + T_2 \cdot p_3 + T_3 \cdot p_1 \quad (\text{EQ. 9}),$$

$$D_3 = T_1 \cdot p_3 + T_2 \cdot p_1 + T_3 \cdot p_2 \quad (\text{EQ. 10}).$$

Here, $D_1$, $D_2$, and $D_3$ are the outputs 426, 427, 428 of the flip-flops 442-444, i.e., the inputs to the DACs 434-436. The errors occur in the DAC outputs 446, 447, 448 due to mismatches in the DACs 434-436 when driven by these inputs.

In at least some implementations, the DEM logic 422 analyzes the mismatch-induced errors by considering specific cases of thermometer-coded inputs and evaluating the errors in the DAC outputs 446-448. The errors in the DAC outputs 446-448, denoted as $e_{DAC_1}$, $e_{DAC_2}$, and $e_{DAC_3}$, are calculated based on the mismatches $\varepsilon_1$, $\varepsilon_2$, and $\varepsilon_3$:

$$e_{DAC_1} = D_1 \cdot \varepsilon_1 \qquad \text{(EQ. 11)},$$

$$e_{DAC_2} = D_2 \cdot \varepsilon_2 \qquad \text{(EQ. 12)},$$

$$e_{DAC_3} = D_3 \cdot \varepsilon_3 \qquad \text{(EQ. 13)}.$$

The cumulative error in the DAC output 446-448 is:

$$e_{DAC_{out}} = e_{DAC_1} + e_{DAC_2} + e_{DAC_3} \qquad \text{(EQ. 14)}$$

For the input combination, $T_1$, $T_2$, $T_3$ = {+1, -1, -1}, substituting the control bits and mismatches, the cumulative error becomes:

$$e_{DAC_{out1}} = (p_1 - p_2 - p_3)\varepsilon_1 + (p_2 - p_3 - p_1)\varepsilon_2 + (p_3 - p_1 - p_2)\varepsilon_3 \qquad \text{(EQ. 15)}.$$

Similarly, for $T_1$, $T_2$, $T_3$ = {+1, +1, -1}, the cumulative error is:

$$e_{DAC_{out2}} = (p_1 - p_2 + p_3)\varepsilon_1 + (p_2 + p_3 - p_1)\varepsilon_2 + (-p_3 + p_1 + p_2)\varepsilon_3 \qquad \text{(EQ. 16)}.$$

To ensure that the cumulative error $e_{DAC_{out}}$ approaches zero over time, the control bits $p_1$, $p_2$, $p_3$ are chosen appropriately. For example, the DEM logic 422 starts with, $p_1$, $p_2$, $p_3$ = {1,0,0} and shift them cyclically every time the conditions $T_1$, $T_2$, $T_3$ = {+1, -1, -1} or {+1, +1, -1} are detected. However, other conditions are applicable as well. This shifting, in at least some implementations, is implemented by rotating the control bits:

$$p_1 \leftarrow p_2,$$

$$p_2 \leftarrow p_3,$$

$$p_3 \leftarrow p_1.$$

By shifting the control bits under these conditions, the mismatch-induced errors alternate in sign, effectively canceling out over multiple cycles. Specifically: For $T_1$, $T_2$, $T_3$ = {+1, -1, -1} with $p_1$, $p_2$, $p_3$ = {1,0,0}:

$$e_{DAC_{out1}} = -(\varepsilon_1 + \varepsilon_2 + \varepsilon_3) \quad \text{(EQ. 17)},$$

and For $T_1$, $T_2$, $T_3$ = {+1, +1, -1} after shifting control bits to $p_1$, $p_2$, $p_3$ = {0,1,0}:

$$e_{DAC_{out2}} = (\varepsilon_1 + \varepsilon_2 + \varepsilon_3) \quad \text{(EQ. 18)}.$$

Given that $\varepsilon_1 + \varepsilon_2 + \varepsilon_3 = 0$, the cumulative error $e_{DAC_{out}}$ effectively becomes zero in both cases, ensuring that the error injected into the DACs 434-436 converge to zero over time.

To further illustrate the error cancelation, Table C below summarizes the DAC outputs 446-448 and errors for different combinations of $D_1$, $D_2$, and $D_3$.

TABLE C

| $D_1$ | $D_2$ | $D_3$ | $DAC_{out}$ | Error $(e_{DAC})$ |
|---|---|---|---|---|
| -1 | -1 | -1 | $-3-(\varepsilon_1 + \varepsilon_2 + \varepsilon_3)$ | 0 |
| 1 | -1 | -1 | $-1 + \varepsilon_1 - \varepsilon_2 - \varepsilon_3$ | $\varepsilon_1 - \varepsilon_2 - \varepsilon_3$ |
| 1 | 1 | -1 | $1 + \varepsilon_1 + \varepsilon_2 - \varepsilon_3$ | $\varepsilon_1 + \varepsilon_2 - \varepsilon_3$ |
| 1 | 1 | 1 | $3+(\varepsilon_1 + \varepsilon_2 + \varepsilon_3)$ | -0 |

In this table, $D_1$, $D_2$, and $D_3$ are the inputs to the DACs 434-436, and the DAC outputs 446-448 include the effects of the mismatches. The cumulative error $e_{DAC}$ is shown in the last column, demonstrating how it cancels out when the sum of mismatches is zero. The analog outputs 446-448 from the DACs 434-436 are summed together using a summation block 450, producing the final DAC output, $DAC_{out}$ 432. This output is then used as a feedback signal (e.g., signal 106 in FIG. 1) in the delta-sigma modulation loop to maintain system stability and performance.

The operation of the system 400 involves various processes working together. For example, the 4-level quantizer 414 generates the thermometer-coded signals $T_1$, $T_2$, $T_3$ from the modulated input signal 412. The update block 438 monitors these signals and determines the next state of the control bits $p_1$, $p_2$, and $p_3$ based on the current state and the thermometer-coded signals. The next state is stored in the flip-flop 440 to ensure synchronization with the system clock. The switching block 420 then uses the updated control bits to dynamically route $T_1$, $T_2$, $T_3$ to the flip-flops 442-444, which drive the DACs 434-436. By aligning the signals with the clock edges, the system 400 maintains consistent operation and reduces the likelihood of transient errors.

FIG. 5 illustrates one example configuration of the update block 438 in the system 400 of FIG. 4. In this example, the update block 438 employs logic to control the dynamic routing of the thermometer-coded signals $T_1$, $T_2$, $T_3$ to the DACs 434-436 by generating control bits $p_1$, $p_2$, and $p_3$. This implementation ensures effective mitigation of mismatch errors in the multi-bit DAC system while maintaining system synchronization.

In this configuration, the update block 438 uses a logic circuit 556 to determine the states of the control bits $p_1$, $p_2$, and $p_3$, based on the thermometer-coded signals $T_1$ 416, $T_2$ 417, and $T_3$ 418. A series of multiplexers (MUXs) 558 (illustrated as MUX 558-1 to MUX 558-9) and flip-flops (DFFs) 540 (illustrated as DFF 440-1 to DFF 440-6) are employed within the update block 438 to generate the control bits and maintain synchronization with the system clock.

Each control bit $p_1$, $p_2$, and $p_3$ is derived by monitoring the relationship between the thermometer-coded signals $T_1$, $T_2$, and $T_3$ and toggling based on predefined conditions. For instance:

Each control bit $p_1$, $p_2$, and $p_3$ is derived by monitoring the relationship between the thermometer-coded signals $T_1$, $T_2$, and $T_3$, and is toggled based on predefined conditions, such as a mismatch condition. For example, the thermometer-coded inputs $T_1$, $T_2$, and $T_3$ are analyzed within the update block 438 to detect specific conditions indicating potential mismatch errors, such as when certain combinations of $T_1$, $T_2$, and $T_3$ occur (e.g.,{+1,-1,-1} or {+1,+1,-1}). When these mismatch conditions are detected, the control bits $p_1$, $p_2$, and $p_3$ are updated by, for example, cyclically shifting their values, to alter the routing of the thermometer-coded signals $T_1$, $T_2$, and $T_3$ in a way that averages out the mismatch errors over time.

The generated control bits $p_1$, $p_2$, and $p_3$ are stored in dedicated flip-flops 440 within the update block 438. These flip-flops 440 ensure that the control bits $p_1$, $p_2$, and $p_3$ are synchronized with the system clock before being passed to the switching block 420. This synchronization is used for maintaining proper timing throughout the circuit.

In operation, the thermometer-coded outputs $T_1$, $T_2$, and $T_3$ are fed into the update block 438, where logic circuits 556 evaluate the conditions for toggling the control bits $p_1$, $p_2$, and $p_3$. When a mismatch condition is detected, the multiplexers 558 within the update block 438 update the control bits $p_1$, $p_2$, and $p_3$ by selecting the next state, which may involve cyclically shifting the control bits (e.g., $p_1 \rightarrow p_2$, $p_2 \rightarrow p_3$, $p_3 \rightarrow p_1$). The updated control bits $p_1$, $p_2$, and $p_3$ are stored in flip-flops 440, ensuring that the switching block 520 receives synchronized signals for dynamic routing.

The updated control bits $p_1$, $p_2$, and $p_3$ from the update block 438 are fed into the switching block 520, which uses them to dynamically shuffle the thermometer-coded signals $T_1$, $T_2$, and $T_3$. This dynamic shuffling redistributes the signals to the DACs 434-436, averaging out mismatch-induced errors over time and improving system performance.

By updating the control bits $p_1$, $p_2$, and $p_3$ based on detected mismatch conditions, the system 500 ensures that positive and negative mismatch errors alternate, leading to effective error cancelation over multiple cycles. The DEM logic 422 implemented in this configuration significantly enhances the linearity and accuracy of the DAC system while minimizing distortion.

The CTDSM described above with respect to FIGs. 1-5 can be implemented in various hardware platforms depending on the intended application and configuration. One implementation option is integrating the CTDSM into a mixed-signal integrated circuit (IC) that incorporates both analog and digital components. In this IC implementation, the analog front-end processes the input signals, while the digital control logic (including the DEM logic implemented in the update blocks and switching blocks) is realized using CMOS technology. This facilitates high-speed operation and low power consumption. The DAC units are fabricated using high-precision analog processes to minimize mismatch and distortion.

Alternatively, the CTDSM can be implemented on a Field-Programmable Gate Array (FPGA). In this FPGA implementation, the digital components, including the DEM logic and update blocks, are synthesized using hardware description languages (HDLs) such as Verilog or VHDL. The analog components, such as the DAC units and loop filters, can be externally interfaced to the FPGA or simulated within the FPGA environment if supported. This approach allows for flexibility in design exploration and iterative development.

In applications requiring high performance and custom optimization, the CTDSM can be integrated within an Application-Specific Integrated Circuit (ASIC). The DEM logic is implemented using digital logic gates optimized for area and power efficiency, while the DAC elements are fabricated using specialized analog processes to achieve high precision and low distortion.

Furthermore, the CTDSM can be implemented as part of a System-on-Chip (SoC) architecture. In this configuration, the modulator is integrated alongside processors, memory, and other subsystems for comprehensive signal processing capabilities. The DEM logic and control mechanisms are implemented digitally within the SoC's logic blocks, while the DAC components are integrated into the mixed-signal interfaces of the chip.

For specialized applications or where modularity is desired, the CTDSM can be implemented using discrete components. The loop filter and DAC elements are realized with analog circuitry, and the DEM logic is implemented digitally on a microcontroller or a small FPGA.

Additionally, the CTDSM can be tailored for specific applications. For example, in audio systems, the CTDSM can be implemented within an audio signal processing IC, providing high-fidelity digital-to-analog conversion for professional-grade audio systems. In biomedical applications, it can be integrated into biomedical signal acquisition devices, offering high-precision conversion of physiological signals for real-time analysis. In wireless communication, the CTDSM can be part of a radio-frequency transceiver IC, enabling low-distortion signal processing for advanced wireless communication systems.

By implementing the CTDSM in these various hardware platforms, the system achieves the desired balance between performance, cost, and application-specific requirements. The integration of analog and digital components allows for effective mitigation of mismatch-induced errors through the DEM logic, ensuring high linearity and accuracy in the digital-to-analog conversion process. Depending on the chosen implementation, the CTDSM can be optimized for low power consumption, high-speed operation, or high-precision applications.

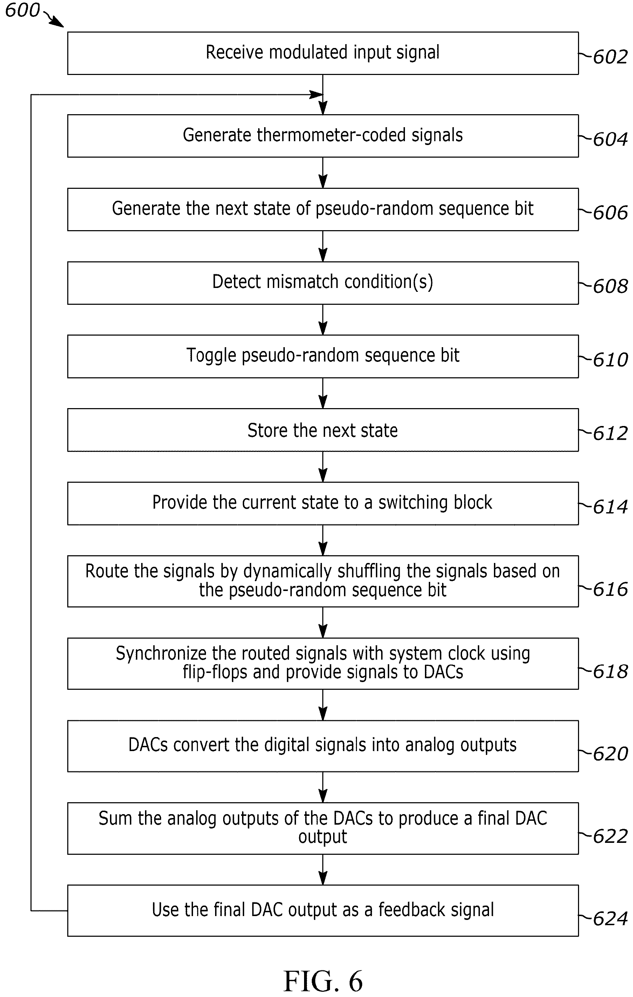

FIG. 6 illustrates a flow diagram of a method 600 for performing dynamic element matching (for a 3-level quantizer and two DAC units). The processes described below with respect to method 600 have been described in greater detail with reference to FIG. 1 to FIG. 3 above. The method 600 is not limited to the sequence of operations shown in FIG. 6, as at least some of the operations can be performed in parallel or in a different sequence. Moreover, in at least some implementations, the method 600 can include one or more different operations than those shown in FIG. 6.

At block 602, the system CTDSM 200 receives a modulated input signal 212 from a continuous-time loop filter 210. This analog signal represents the input that needs to be quantized and converted back to analog form. At block 604, the input signal 212 is processed by the 3-level quantizer 214. The quantizer 214 converts the continuous-time analog signal into discrete digital levels, producing thermometer-coded outputs $T_1$ and $T_2$.

At block 606, the thermometer-coded signals $T_1$ and $T_2$ are input into the update block 238. The update block 238 generates the next state of the pseudo-random sequence $PN_{i+1}$ based on the current state $PN_i$ and the condition $T_1 \neq T_2$. At block 608, the update block 238 uses logic gates (e.g., an XOR gate or an AND gate and a NOT gate) to detect if $T_1 \neq T_2$. This condition indicates a potential accumulation of mismatch-induced errors. At block 610, if $T_1 \neq T_2$, the update block 238 toggles the pseudo-random sequence bit by setting $PN_{i+1} = 1 - PN_i$. This toggling ensures that mismatch-induced errors alternate in sign, effectively canceling out over time.

At block 612, the next state $PN_{i+1}$ is stored in a flip-flop 240 within the update block to ensure proper synchronization with the system clock. This flip-flop 240 provides the updated current state $PN_i$ for use in the next cycle. At block 614, the current state $PN_i$ is provided to the switching block 220. The switching block 220 includes part of the DEM logic 222 and uses $PN_i$ to control the dynamic routing of the thermometer-coded signals.

At block 616, the switching block 220 uses the pseudo-random sequence $PN_i$ to dynamically shuffle the thermometer-coded signals $T_1$ and $T_2$. The dynamic shuffling is performed by routing the signals to different paths based on the value of $PN_i$. For example, if $PN_i = 0.$, $T_1$ and $T_2$ are routed normally. If $PN_i = 1.$, $T_1$ and $T_2$ are swapped. At block 618, the dynamically routed signals are passed through flip-flops 242, 244 to synchronize them with the system clock before reaching the DACs 234, 236. This step ensures proper timing and reduces the likelihood of glitches.

At block 620, the synchronized signals $D_1$, $D_2$ are input into the DACs 234, 236 with normalized weights. At block 622, the DACs 234, 236 convert the digital signals $D_1$, $D_2$ into analog outputs, accounting for their respective mismatches, and the analog outputs from the DAC 234, 236 are summed in the summation block 250 to produce the final DAC output, $DAC_{out}$ 232. At block 626, the $DAC_{out}$ 232 is used as a feedback signal in the CTDSM loop, maintaining system stability and accuracy by correcting any deviations from the desired output. The process then loops back to block 604, where the next input signal is processed, and the flow continues to dynamically average out the mismatch-induced errors over time.

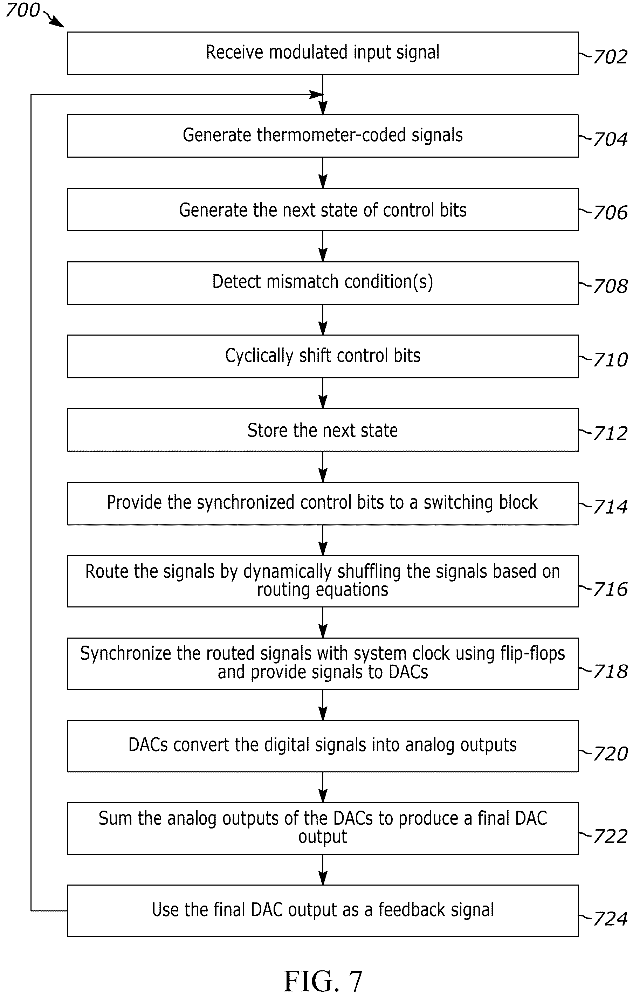

FIG. 7 illustrates a flow diagram of a method 700 for performing dynamic element matching using control bits (for a 4-level quantizer and three DAC units). The processes described below with respect to method 700 have been described in greater detail with reference to FIG. 1, FIG. 4, and FIG. 5. The method 700 is not limited to the sequence of operations shown in FIG. 7, as at least some of the operations can be performed in parallel or in a different sequence. Moreover, in at least some implementations, the method 700 can include one or more different operations than those shown in FIG. 7.

At block 702, the CTDSM 400 receives a modulated input signal 412 from a continuous-time loop filter 410. This analog signal represents the input that needs to be quantized and converted back to analog form. At block 704, the input signal 412 is processed by the 4-level quantizer 414. The quantizer 414 converts the continuous-time analog signal into discrete digital levels, producing three thermometer-coded outputs $T_1$, $T_2$, and $T_3$. At block 706, the thermometer-coded signals $T_1$, $T_2$, and $T_3$ are input into the update block 438. The update block 438 generates the next state of the control bits $p_1$, $p_2$, and $p_3$ based on the current state and the thermometer-coded signals.

At block 708, the update block 438 analyzes the thermometer-coded signals to detect mismatch conditions indicating potential accumulation of mismatch-induced errors. At block 710, if a mismatch condition is detected, the update block 438 updates the control bits by cyclically shifting their values. This shifting alters the routing of the thermometer-coded signals to the DACs 434-436, ensuring that mismatch-induced errors alternate in sign and effectively cancel out over time. At block 712, the next state of the control bits $p_1$, $p_2$, and $p_3$ is stored in flip-flops 440 within the update block to ensure proper synchronization with the system clock. This synchronization maintains timing accuracy throughout the system 400.

At block 714, the synchronized control bits $p_1$, $p_2$, and $p_3$ are provided to the switching block 420. The switching block 420 uses these control bits to dynamically shuffle the thermometer-coded signals $T_1$, $T_2$, and $T_3$. At block 716, the switching block 420 dynamically routes the thermometer-coded signals $T_1$, $T_2$, and $T_3$ to the flip-flops 442-444, as described above. This dynamic routing ensures that the mismatch-induced errors from the DAC units are averaged out over time. At block 718, the dynamically routed signals are passed through the flip-flops 442-444 to synchronize them with the system clock before reaching the DACs 434-436. This step ensures proper timing and reduces the likelihood of transient errors.

At block 720, the synchronized signals $D_1$, $D_2$, and $D_3$ are input into the DACs 434-436 with normalized weights such that mismatch errors are accounted for, and the DACs 434-436 convert the digital signals $D_1$, $D_2$, and $D_3$ into analog outputs, accounting for their respective mismatches. The errors in the DAC outputs 446-448 are then calculated. At block 722, the analog outputs 446-448 from the DACs 434-436 are summed in the summation block 450 to produce the final DAC output, $DAC_{out}$ 232. In at least some implementations, the cumulative error in the DAC output 432 is calculated. At block 724, the DAC output, $DAC_{out}$ 232 is used as a feedback signal in the CTDSM loop, maintaining system stability and high accuracy by correcting any deviations from the desired output. The process then loops back to block 704, where the next input signal is processed, and the flow continues to dynamically average out the mismatch-induced errors over time.

The present disclosure describes a method for mitigating mismatch-induced errors in a continuous-time delta-sigma modulator (CTDSM) system, such as system 200 illustrated in FIGs. 2 and 3 or system 400 in FIGs. 4 and 5. The method involves various processes to enhance the accuracy and performance of the CTDSM. At the outset, the system receives an analog input signal (212 in system 200 and 412 in system 400), which may be the modulated output from a continuous-time loop filter (112 in FIG. 1). This analog signal is quantized by a quantizer (214 in system 200 and 414 in system 400), which converts the continuous-time analog input into one or more thermometer-coded digital signals. These thermometer-coded signals represent discrete digital levels corresponding to the analog input signal, enabling precise digital representation for further processing.

In response to quantizing the analog input signal, control signals are generated based on the thermometer-coded digital signals. An update block (238 in system 200 and 438 in system 400) analyzes the thermometer-coded signals and produces control signals. These control signals are used for dynamically routing the thermometer-coded signals in a manner that mitigates mismatch-induced errors.

The thermometer-coded digital signals are then dynamically routed to a plurality of digital-to-analog converter (DAC) elements (DACs 234 and 236 in system 200 and DACs 434, 435, and 436 in system 400) based on the generated control signals. This dynamic routing is performed by a switching block (220 in system 200 and 420 in system 400), which implements the DEM logic (222 in system 200 and 422 in system 400). By dynamically shuffling the thermometer-coded signals, the system averages out mismatches over time, thereby reducing distortion and enhancing the linearity of the DAC outputs.

Following the dynamic routing, the analog outputs (246 and 248 in system 200 and 446, 447, and 448 in system 400) from the DAC elements are combined in a summation block (250 in system 200 and 450 in system 400) to produce a final analog output ($DAC_{out}$ 232 in system 200 and $DAC_{out}$ 432 in system 400). This final analog output is used as a feedback signal for the CTDSM system. By utilizing this feedback, the system maintains stability and accuracy, correcting any deviations from the desired output and effectively mitigating mismatch-induced errors.

The CTDSM system, such as system 200 depicted in FIGs. 2 and 3 or system 400 shown in FIGs. 4 and 5, comprises various components configured to mitigate mismatch-induced errors effectively. A quantizer (214 in system 200 and 414 in system 400) is configured to receive an analog input signal (212 in system 200 and 412 in system 400) and quantize it into one or more thermometer-coded digital signals. These signals represent the quantized levels of the input signal, enabling high-resolution digital processing.

An update block (238 in system 200 and 438 in system 400) is configured to generate control signals based on the thermometer-coded digital signals. The update block analyzes the thermometer-coded signals to detect conditions that may lead to mismatch-induced errors and produces control signals accordingly. This ensures that the dynamic routing of signals effectively averages out mismatches over time.

A switching block (220 in system 200 and 420 in system 400) is configured to dynamically route the thermometer-coded digital signals to a plurality of digital-to-analog converter (DAC) elements (234 and 236 in system 200 and 434, 435, and 436 in system 400) based on the control signals. The DAC elements are configured to convert the thermometer-coded digital signals into analog outputs (246 and 248 in system 200 and 446, 447, and 448 in system 400). This dynamic routing minimizes the cumulative effect of component mismatches, enhancing the system's linearity and accuracy.

A summation block (250 in system 200 and 450 in system 400) is configured to combine the analog outputs from the DAC elements to produce a final analog output ($DAC_{out}$ 232 in system 200 and $DAC_{out}$ 432 in system 400). This output serves as a feedback signal for the CTDSM system, provided via a feedback path (106 in FIG. 1), maintaining system stability and performance by correcting any deviations from the desired output.

Furthermore, the switching block is configured to route the thermometer-coded digital signals through a plurality of flip-flops (242 and 244 in system 200 and 442, 443, and 444 in system 400) synchronized with a system clock before providing the signals to the DAC elements. This synchronization ensures proper timing and reduces the likelihood of glitches, maintaining consistent operation throughout the system.

The CTDSM system 200 illustrated in FIGs. 2 and 3 includes components configured to mitigate mismatch-induced errors effectively. The system includes a quantizer 214, which is configured to quantize an analog input signal 212 into thermometer-coded digital signals. These thermometer-coded signals represent discrete digital levels necessary for high-resolution digital-to-analog conversion.

An update block 238 is configured to detect at least one mismatch condition in the thermometer-coded digital signals and toggle a pseudo-random sequence bit in response to detecting such conditions. In at least some implementations, the update block 238 analyzes the thermometer-coded signals to identify specific combinations that indicate potential mismatch-induced errors. Upon detection, the update block 238 toggles the pseudo-random sequence bit, thereby generating updated control signals.

A switching block 220 is configured to dynamically shuffle the thermometer-coded digital signals based on the pseudo-random sequence bits generated by the update block 238. This dynamic shuffling redistributes the digital signals to the digital-to-analog converter (DAC) elements 234, 236, effectively averaging out mismatch-induced errors over time. The switching block 220 routes the shuffled signals to the DAC elements via synchronized flip-flops 242, 244, which ensure proper timing and reduce the likelihood of glitches.

Each DAC element 234, 236 is configured to receive the dynamically shuffled thermometer-coded digital signals and convert them into analog outputs 246, 248. Due to inherent process variations, each DAC element may exhibit mismatches represented by normalized weights. By dynamically shuffling the thermometer-coded signals, the system 200 minimizes the cumulative effect of these component mismatches.

The analog outputs from the DAC elements 246, 248 are combined in a summation block 250 to produce the final analog output $DAC_{out}$ 232. This output serves as a feedback signal in the CTDSM loop, maintaining system stability and high accuracy by correcting any deviations from the desired output.

The disclosure extends to a continuous-time delta-sigma modulator (CTDSM) system, comprising: a quantizer configured to quantize an analog input signal into thermometer-coded digital signals; an update block configured to: detect at least one mismatch condition in the thermometer-coded digital signals; and toggle a pseudo-random sequence bit in response to detecting the at least one mismatch condition; a switching block configured to shuffle the thermometer-coded digital signals based on the pseudo-random sequence bit to average mismatch-induced errors over time; a plurality of digital-to-analog converter (DAC) elements, each configured to: receive the shuffled thermometer-coded digital signals; and convert the thermometer-coded digital signals into analog outputs; and a summation block configured to combine the analog outputs of the DAC elements to produce a final analog output.

In one ore more embodiments, the switching block is further configured to: route the thermometer-coded digital signals through a plurality of flip-flops synchronized with a system clock before providing the signals to the plurality of DAC elements.

Although specific examples of the subject matter have been disclosed, those having ordinary skill in the art will understand that changes can be made to the specific examples without departing from the scope of the disclosed subject matter. The scope of the disclosure is not to be restricted, therefore, to the specific examples..

**Claims**

1. A method for mitigating mismatch-induced errors in a continuous-time delta-sigma modulator, CTDSM, system, the method comprising:

   responsive to quantizing an analog input signal into one or more thermometer-coded digital signals using a quantizer, generating control signals based on the thermometer-coded digital signals;
   routing the thermometer-coded digital signals to a plurality of digital-to-analog converter, DAC, elements based on the control signals;
   responsive to routing the thermometer-coded digital signals, combining analog outputs from the DAC elements to produce an analog output; and
   using the analog output as a feedback signal for the CTDSM system.

2. The method of claim 1, wherein the routing of the thermometer-coded digital signals comprises:
   detecting at least one mismatch conditions in the thermometer-coded digital signals.

3. The method of claim 2, wherein detecting mismatch conditions comprises:
   detecting that at least two of the thermometer-coded digital signals are unequal.

4. The method of claim 2 or 3, wherein generating the control signals comprises:

   generating the control signals by toggling a pseudo-random sequence bit in response to detecting the at least one mismatch condition; or
   cyclically shifting a set of control bits in response to detecting the at least one mismatch condition.

5. The method of any preceding claim, wherein the routing of the thermometer-coded digital signals comprises:
   shuffling the thermometer-coded digital signals to a plurality of flip-flops using the control signals to average mismatch-induced errors over time.

6. The method of any preceding claim, further comprising:
   synchronizing the control signals with a system clock using a flip-flop before providing the control signals for routing.

7. The method of any preceding claim, wherein routing the thermometer-coded digital signals comprises:
   routing the thermometer-coded digital signals to the plurality of DAC elements based on a combination of the control signals and predefined routing logic.

8. The method of any preceding claim, further comprising:
   configuring the plurality of DAC elements with mismatch weights such that the sum of the mismatch weights satisfies a condition that cancels cumulative mismatch errors.

9. The method of any preceding claim, wherein using the analog output as the feedback signal for the CTDSM system comprises:
   using the feedback signal to correct deviations between the analog input signal and the analog output.

10. A continuous-time delta-sigma modulator, CTDSM, system, comprising:

    a quantizer configured to quantize an analog input signal into one or more thermometer-coded digital signals;
    an update block configured to generate control signals based on the thermometer-coded digital signals;
    a switching block configured to route the thermometer-coded digital signals to a plurality of digital-to-analog converter, DAC, elements based on the control signals, wherein the plurality of DAC elements configured to convert the thermometer-coded digital signals into analog outputs;
    a summation block configured to combine the analog outputs from the plurality of DAC elements to produce a final analog output; and
    a feedback path configured to use the final analog output as a feedback signal for the CTDSM system.

11. The CTDSM system of claim 10, wherein the update block is further configured to:
    detect at least one mismatch condition in the thermometer-coded digital signals.

12. The CTDSM system of claim 11, wherein the update block is configured to detect the at least one mismatch condition by detecting that at least two of the thermometer-coded digital signals are unequal.

13. The CTDSM system of claim 11 or 12, further configured to:

   generate the control signals by toggling a pseudo-random sequence bit in response to detecting the at least one mismatch condition; or
   cyclically shift a set of control bits in response to detecting the at least one mismatch condition.

14. The CTDSM system of any of claims 10 to 13, wherein the switching block is further configured to:
   shuffle the thermometer-coded digital signals to a plurality of flip-flops using the control signals to average mismatch-induced errors over time.

15. The CTDSM system of any of claims 10 to 14, further comprising:
   at least one flip-flop configured to synchronize the control signals with a system clock before providing the control signals to the switching block for routing.

FIG. 1

FIG. 2

EP 4 776 514 A1

FIG. 3

FIG. 4

FIG. 5

600

| Receive modulated input signal | ~602 |

| Generate thermometer-coded signals | ~604 |

| Generate the next state of pseudo-random sequence bit | ~606 |

| Detect mismatch condition(s) | ~608 |

| Toggle pseudo-random sequence bit | ~610 |

| Store the next state | ~612 |

| Provide the current state to a switching block | ~614 |

| Route the signals by dynamically shuffling the signals based on the pseudo-random sequence bit | ~616 |

| Synchronize the routed signals with system clock using flip-flops and provide signals to DACs | ~618 |

| DACs convert the digital signals into analog outputs | ~620 |

| Sum the analog outputs of the DACs to produce a final DAC output | ~622 |

| Use the final DAC output as a feedback signal | ~624 |

FIG. 6

700

```
Receive modulated input signal                                              ~702

Generate thermometer-coded signals                                          ~704

Generate the next state of control bits                                     ~706

Detect mismatch condition(s)                                                ~708

Cyclically shift control bits                                               ~710

Store the next state                                                        ~712

Provide the synchronized control bits to a switching block                  ~714

Route the signals by dynamically shuffling the signals based on
routing equations                                                           ~716

Synchronize the routed signals with system clock using flip-flops
and provide signals to DACs                                                 ~718

DACs convert the digital signals into analog outputs                        ~720

Sum the analog outputs of the DACs to produce a final DAC
output                                                                      ~722

Use the final DAC output as a feedback signal                               ~724
```

FIG. 7

Europäisches
Patentamt
European
Patent Office
Office européen
des brevets

# EUROPEAN SEARCH REPORT

**Application Number**

EP 26 15 0420

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 697 003 B1 (CHEN FENG [US]) 24 February 2004 (2004-02-24) * figures 1,7 * | 1,5-7,9, 10,14,15 | INV. H03M1/06 H03M3/00 |
| X | US 2016/006448 A1 (MELANSON JOHN L [US] ET AL) 7 January 2016 (2016-01-07) * columns 1,5; figure 1 * | 1,9,10 | |
| X | HONG PHUC NINH ET AL: "A 83-dB SFDR 10-MHz bandwidth continuous-time Delta-Sigma modulator employing a one-element-shifting dynamic element matching", RADIO-FREQUENCY INTEGRATION TECHNOLOGY (RFIT), 2011 IEEE INTERNATIONAL SYMPOSIUM ON IEEE, 30 November 2011 (2011-11-30), pages 109-112, XP032103894, DOI: 10.1109/RFIT.2011.6141779 ISBN: 9781457705175 * paragraphs [0003], [0004], [0029], [0033], [0069]; claims 1,14,15; figures 1,3 * | 1-4,9-13 | |
| X | EP 3 672 082 A1 (NXP USA INC [US]) 24 June 2020 (2020-06-24) * paragraphs [0004], [0006], [0010], [0022]; claim 1; figures 1,3,7,8,9 * | 1-3,8-12 | TECHNICAL FIELDS SEARCHED (IPC) H03M |

The present search report has been drawn up for all claims

| Place of search | Date of completion of the search | Examiner |
|---|---|---|
| The Hague | 29 May 2026 | Jesus, Paulo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.........................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 26 15 0420

This annex lists the patent family members relating to the patent documents cited in the above-mentioned European search report.
The members are as contained in the European Patent Office EDP file on
The European Patent Office is in no way liable for these particulars which are merely given for the purpose of information.

29-05-2026

| Patent document cited in search report | | Publication date | Patent family member(s) | | Publication date |
|---|---|---|---|---|---|
| US 6697003 | B1 | 24-02-2004 | NONE | | |
| US 2016006448 | A1 | 07-01-2016 | GB | 2547322 A | 16-08-2017 |
| | | | GB | 2588741 A | 05-05-2021 |
| | | | US | 2016006448 A1 | 07-01-2016 |
| | | | WO | 2016003648 A2 | 07-01-2016 |
| EP 3672082 | A1 | 24-06-2020 | EP | 3672082 A1 | 24-06-2020 |
| | | | US | 10298257 B1 | 21-05-2019 |

EPO FORM P0459

For more details about this annex : see Official Journal of the European Patent Office, No. 12/82